# EUROPEAN PATENT APPLICATION

(11) **EP 4 502 624 A1**
(43) Date of publication of application: **05.02.2025**
(21) Application number: 23774505.4
(22) Date of filing: 07.03.2023
(51) Int. Cl.: G01R 1/067, G01R 1/06, H01R 13/24

(54) **SPRING CONNECTOR**

(30) Priority: 25.03.2022 JP 2022049334
(71) Applicant: Yokowo Co., Ltd, Tokyo 101-0041 (JP)
(72) Inventor: SUDA Masaya, Tomioka-Shi, Gunma 370-2495 (JP); AKIYA Ryosuke, Tomioka-Shi, Gunma 370-2495 (JP); HIRANO Shogo, Tomioka-Shi, Gunma 370-2495 (JP); TAGAWA Yoshio, Tomioka-Shi, Gunma 370-2495 (JP)
(74) Representative: Gunzelmann, Rainer
(86) International application number: PCT/JP2023/008486
(87) International publication number: WO 2023/181906

(57) **Abstract**

Provided is a spring connector capable of facilitating stabilized lateral pressure for pressing a pin toward a tube inner wall. This spring connector comprises: a conductive tube; a conductive pin freely slidable in the conductive tube; and a coil spring that is installed in the tube and that biases the pin in a direction of projecting from the tube. The coil spring has a sparsely wound part and a densely wound part positioned on an end side of the sparsely wound part and engaged with the pin. The diameter of the densely wound part is smaller than that of the sparsely wound part, and the center axis of the densely wound part is offset from the center axis of the sparsely wound part. Thus, the lateral pressure for pressing the pin toward the inner wall of the tube can be generated substantially constantly.

## Description

### TECHNICAL FIELD

The present invention relates to a spring connector used in a portion in which electrical connection is detachably performed in various electronic devices.

### BACKGROUND ART

In general, a spring connector includes a pin, a tube that holds the pin in a slidable manner, and a spring that is accommodated in the tube and biases a distal end portion of the pin in a direction in which the pin protrudes from inside of the tube.

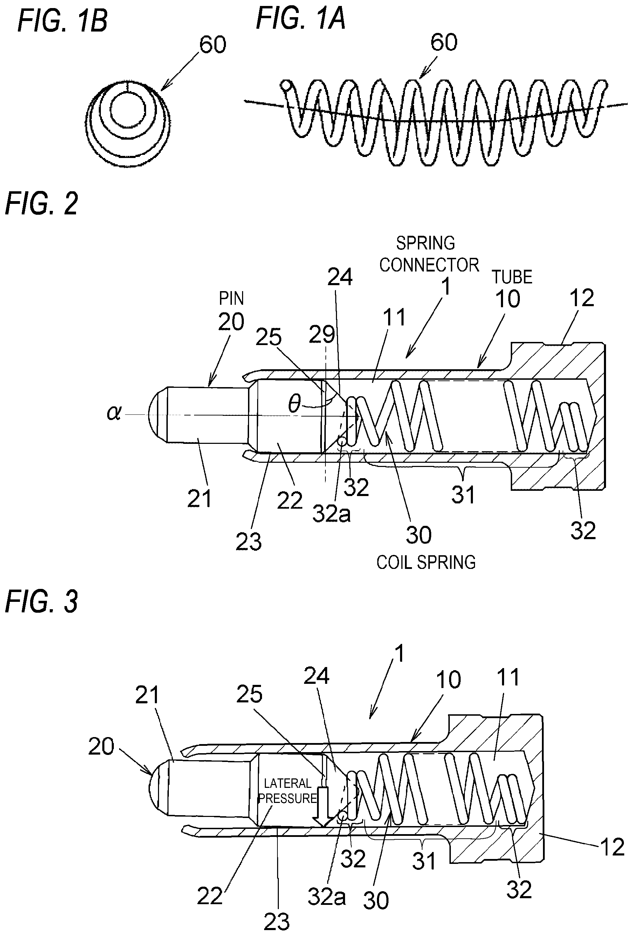

In the following Patent Literature 1, as an example of a spring connector, a spring connector is shown in which a portion (hereinafter, referred to as a pin bottom surface) of a pin that comes into contact with a spring is processed into a conical shape. In this example, a spring is installed in a space formed by the pin and a hole of a tube, and as shown in FIG. 1A and FIG. 1B, a spring 60 includes a central portion that has a substantially equal diameter and a tapered portion that is adjacent to the central portion, has a gradually reduced diameter, and has a central axis offset in an oblique direction from the central axis of the central portion. In this case, the central axis of the tapered portion intersects the central axis of the central portion. When the pin is pushed, both ends of the spring are compressed by a conical portion of the pin bottom surface and a tube hole bottom surface. At this time, since the pin receives a load in a direction inclined from an axial direction of the tube due to the tapered portion of the spring, the pin is in an inclined state, and the pin is pressed against an inner wall of the tube to generate lateral pressure corresponding to a compression amount of the spring in the axial direction.

### CITATION LIST

### PATENT LITERATURE

Patent Literature 1: Japanese Patent No. 5197754

### SUMMARY OF INVENTION

### TECHNICAL PROBLEM

In the case of the spring connector in which the pin bottom surface is processed into a conical shape, there is a problem in that the lateral pressure for pressing the pin against the tube inner wall depends on the compression amount of the spring, and the lateral pressure is not stable.

An example of an object of the present invention is to provide a spring connector capable of stabilizing a lateral pressure for pressing a pin against an inner wall of a tube. Other objects of the present invention will become apparent from the description of this specification.

### SOLUTION TO PROBLEM

An aspect of the present invention includes: a conductive tube; a conductive pin that is slidable in the tube; and a spring that is provided in the tube and biases the pin in a direction in which the pin protrudes from the tube, in which the spring includes a roughly wound portion and a densely wound portion positioned on an end portion side of the roughly wound portion and engaged with the pin, and a diameter of the densely wound portion is smaller than a diameter of the roughly wound portion, and a central axis of the densely wound portion and a central axis of the roughly wound portion are different from each other.

The pin may include a protruding portion protruding outside of the tube and an inlet pipe portion positioned in the tube, and the inlet pipe portion may include a sliding portion that is slidable with respect to an inner wall of the tube and a conical portion engaged with the densely wound portion of the spring.

A boundary portion between the sliding portion and the conical portion may have a curved shape.

An outer peripheral end of the roughly wound portion and an outer peripheral end of the densely wound portion may be aligned on an outer side in a direction in which the central axis of the densely wound portion is offset with respect to the central axis of the roughly wound portion.

The densely wound portion may be provided on each of both end sides of the roughly wound portion.

Central axes of the densely wound portions provided on both end sides of the roughly wound portion may be offset in the same direction with respect to the central axis of the roughly wound portion.

The central axes of the densely wound portions provided on both end sides of the roughly wound portion may be coaxial with each other.

The central axes of the densely wound portions provided on both end sides of the roughly wound portion may be offset in opposite directions across a central axis of the roughly wound portion.

A cutting end portion of the spring may be positioned closer to an inner wall side of the tube than the central axis of the densely wound portion in a direction in which the central axis of the densely wound portion is offset from the central axis of the roughly wound portion.

The central axis of the densely wound portion and the central axis of the roughly wound portion may be substantially parallel to each other.

The inlet pipe portion may have a flat surface portion surrounding the conical portion on an end surface facing the spring.

Any combination of the above components and conversion of the expression of the present invention between methods and systems are also effective as aspects of the present invention.

According to the spring connector of the present invention, a lateral pressure for pressing the pin against the inner wall of the tube can be stabilized.

### BRIEF DESCRIPTION OF DRAWINGS

FIGS. 1A and 1B are views of a coil spring used in a spring connector in the related art, in which FIG. 1A is a front view, and FIG. 1B is a left side view.
FIG. 2 is an explanatory view of Embodiment 1 of a spring connector according to the present invention when no load is applied to a pin.
FIG. 3 is an explanatory view of a state in which the same pin is pushed toward a tube side by a load applied to the pin.
FIGS. 4A and 4B are views of a coil spring used in Embodiment 1, in which FIG. 4A is a front view, and FIG. 4B is a left side view.
FIGS. 5A and 5B are views of a main part according to Embodiment 1, in which FIG. 5A is an explanatory view of a main part of the spring connector, and FIG. 5B is a side view of a side of the coil spring in contact with the pin.
FIG. 6 is an explanatory view showing a conduction path when the pin is pushed in Embodiment 1.
FIG. 7 is a graph showing a relation between a displacement amount [mm], a load [N], and a resistance value [mΩ] due to the pushing of the pin in Embodiment 1.
FIG. 8 is an explanatory view showing a usage example of the spring connector shown in Embodiment 1.
FIGS. 9A and 9B are views of a main part according to Embodiment 2 of the present invention, in which FIG. 9A is an explanatory view of a main part of the spring connector, and FIG. 9B is a side view of a side of the coil spring in contact with the pin.
FIG. 10 is an explanatory view showing Embodiment 3 of the spring connector according to the present invention.
FIG. 11 is an explanatory view showing Embodiment 4 of the spring connector according to the present invention.
FIG. 12 is a front view showing a modification of the coil spring used in the spring connector according to the present invention.

### DESCRIPTION OF EMBODIMENTS

Hereinafter, preferred embodiments of the present invention will be described in detail with reference to the drawings. The same or equivalent components, members, processes, and the like shown in the drawings are denoted by the same reference numerals, and redundant description thereof will be omitted as appropriate. The embodiments are not intended to limit the invention but are mere exemplifications, and all features and combinations thereof described in the embodiments are not necessarily essential features of the invention.

### Embodiment 1

Embodiment 1 of a spring connector according to the present invention will be described with reference to FIGS. 2 to 7. In the drawings, a spring connector 1 includes a conductive tube 10, a conductive pin 20 that is slidable in the tube 10, and a coil spring 30 provided in the tube 10.

The tube 10 has a bottomed cylindrical shape having a cylindrical hollow portion 11 inside, and a base portion thereof is a flange portion 12 having a wide width. The flange portion 12 is a portion fixed to an electrode of a substrate or the like by soldering or the like.

The pin 20 includes a protruding portion 21 that protrudes from the inside of the tube 10 to the outside of the tube 10 and serves as an external contact portion, and an inlet pipe portion 22 inserted into the tube 10 and positioned in the cylindrical hollow portion 11. The inlet pipe portion 22 is a portion of the pin 20 that enters the tube 10, and includes a sliding portion 23 that faces an inner wall of the cylindrical hollow portion 11 of the tube 10 and is slidable. When an axis that passes through a center of the pin 20 and is substantially parallel to a sliding direction of the pin 20 is defined as a pin central axis α, and a conical portion 24 that is rotationally symmetrical with respect to the pin central axis α is formed on an end surface of the inlet pipe portion 22 on a side opposite to the side at which the protruding portion 21 is provided. The conical portion 24 protrudes in a direction opposite to a direction in which the protruding portion 21 of the pin 20 protrudes, and an angle θ formed by a vertical surface 29 with respect to the pin central axis α and a surface of the conical portion 24 is approximately 45°. The angle θ is not limited to about 45° and can be appropriately set within a range of 30° to 60°.

A boundary portion 25 between the sliding portion 23 and the conical portion 24 of the pin 20 has a curved shape having a predetermined curvature. The inlet pipe portion 22 is larger in diameter than the protruding portion 21, and an opening diameter of a distal end portion of the tube 10 is processed so that the inlet pipe portion 22 does not come out of the cylindrical hollow portion 11 and fall off, that is, the opening diameter is smaller in diameter than the inlet pipe portion 22.

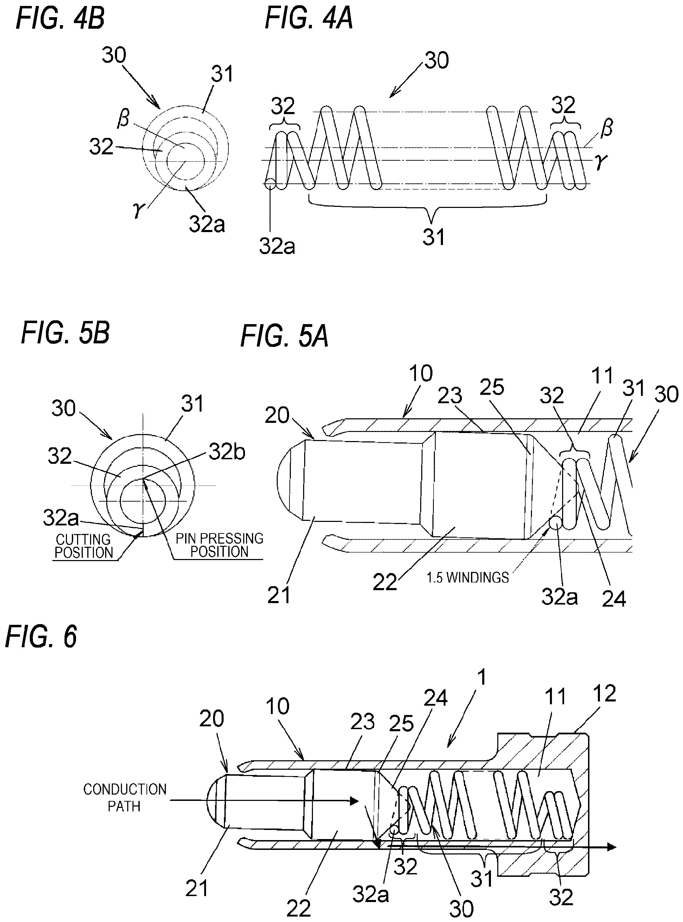

The coil spring 30 is formed by winding an elastic metal wire, and functions as a compression spring to bias the pin 20 in a direction in which the pin 20 protrudes from the tube 10. As shown in FIG. 4A and FIG. 4B, the coil spring 30 includes a roughly wound portion 31 wound to have a constant outer diameter, and densely wound portions 32 positioned on both end portion sides of the roughly wound portion 31. The densely wound portions 32 form an end wound portion, and one of the densely wound portion 32 is engaged with the conical portion 24 of the pin 20. However, the densely wound portion 32 is not limited to an end-turning state, and may be in a more densely wound state than the roughly wound portion 31. The roughly wound portion 31 is a portion functioning as a spring at the time of compression and generates a force in a direction in which the pin 20 protrudes out of the tube 10 at the time of compression. The outer diameter of the roughly wound portion 31 is, for example, 1.15 mm and is slightly smaller than an inner diameter of the cylindrical hollow portion 11, and a central axis β of the roughly wound portion 31 is not curved and substantially maintains a straight line. An outer diameter of the densely wound portion 32 is, for example, 0.8 mm and is smaller than the outer diameter of the roughly wound portion 31, and an inner diameter of the densely wound portion 32 is larger than a radius of the sliding portion 23 of the pin 20. The outer diameters of the roughly wound portion 31 and the densely wound portion 32 are not limited to the above values. The central axis β of the roughly wound portion 31 and a central axis γ of the densely wound portion 32 are different from each other, and the central axes are formed to be substantially parallel to each other over the entire length of the coil spring 30. In other words, the central axis γ of the densely wound portion 32 is offset (eccentric) with respect to the central axis β of the roughly wound portion 31. The pin 20 and the coil spring 30 are engaged with each other in a state at which an apex of the conical portion 24 is positioned inside the inner diameter of the densely wound portion 32.

In the example of FIG. 4A and FIG. 4B, the coil spring 30 is in a no-load state, and the central axes γ of the densely wound portions 32 provided on both end sides of the roughly wound portion 31 are coaxial with each other. In manufacturing, a case in which there is a tolerance between the central axes of the densely wound portions 32 at both ends is regarded as being coaxial. When the central axis β of the roughly wound portion 31 is viewed from a protruding side of the pin 20 (hereinafter, referred to as viewed from a central axis β direction), an outer peripheral end of the roughly wound portion 31 and an outer peripheral end of the densely wound portion 32 are aligned with each other on an outer side in a direction (eccentric direction) in which the central axis γ of the densely wound portion 32 is offset with respect to the central axis β of the roughly wound portion 31. In other words, as shown in a left side view of (B) of FIG. 4, an outer peripheral circle of the densely wound portion 32 is inscribed in an outer peripheral circle of the roughly wound portion 31. The winding number of the densely wound portion 32 is 1.5 windings. A cutting end portion 32a of the densely wound portion 32 of the coil spring 30 is positioned on an outer side in a direction in which the central axis γ of the densely wound portion 32 is offset with respect to the central axis β of the roughly wound portion 31. That is, the cutting end portion 32a is positioned closer to the inner wall side of the tube 10 than the central axis γ of the densely wound portion 32.

When the pin 20 and the coil spring 30 are accommodated in the cylindrical hollow portion 11 of the tube 10, a distal end of the conical portion 24 of the pin 20 is positioned inside the inner diameter of the densely wound portion 32, during assembly, the distal end of the conical portion 24 is inducted into the densely wound portion 32 of the eccentric coil spring 30, and the densely wound portion 32 engages with the conical portion 24.

The tube 10 and the pin 20 are subjected to a plating process to maintain good conductivity. For example, the base is nickel (Ni) plating, and the surface is gold (Au) plating.

In the configuration of Embodiment 1 described above, when the pin 20 is pressed against the electrode or the like of an opposite device from the no-load state of FIG. 2, the pin 20 is pushed into the tube 10 as shown in FIG. 3. Accordingly, both ends of the coil spring 30 are compressed by the conical portion 24 of the pin 20 and the bottom surface of the tube 10. At this time, since the distal end of the conical portion 24 of the pin 20 is positioned inside the inner diameter of the eccentric densely wound portion 32 as shown in FIG. 5A, the conical portion 24 is pressed at a pressing position 32b on an inner periphery of the densely wound portion 32 as shown in FIG. 5B. As a result, the coil spring 30 is compressed in a state in which an offset amount of the central axis γ of the densely wound portion 32 with respect to the central axis β of the roughly wound portion 31 is reduced. The coil spring 30 generates a force to return from a compressed state to the state of FIG. 4B when no load is applied (a state in which the outer peripheral end of the roughly wound portion 31 and the outer peripheral end of the densely wound portion 32 are aligned on the outer side in the offset direction (eccentric direction)). As a result, a lateral pressure is generated in a direction of an arrow in FIG. 3, and the boundary portion 25 between the sliding portion 23 and the conical portion 24 of the pin 20 is normally in contact with an inner wall surface of the tube 10. As shown in FIG. 6, the conduction path of the spring connector 1 is a path of the pin 20, the boundary portion 25 of the pin 20 pressed against the inner wall surface of the tube 10 by the lateral pressure, and the tube 10.

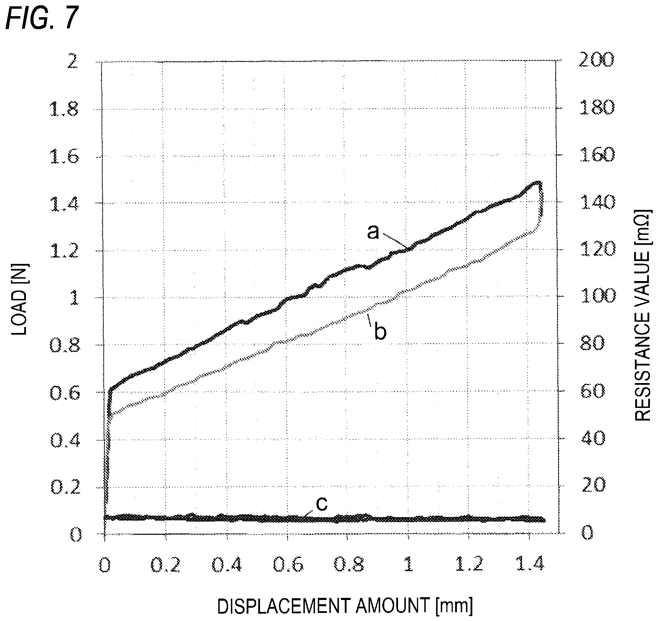

Next, the fact that the lateral pressure for pressing the pin 20 against the inner wall surface of the tube 10 is stable regardless of the compression amount of the coil spring 30 will be described with reference to FIG. 7. An upper inclined line a in FIG. 7 represents a relation between the pin displacement amount [mm] and the load [N] when the pin 20 is pushed from the displacement amount of 0 mm to about 1.45 mm by applying a load thereto, and the load at this time is [reaction force of the coil spring 30 + frictional force (depending on the lateral pressure) at the time of pushing]. A lower inclined line b in FIG. 7 represents a relation between the pin displacement amount [mm] and the load [N] when the load of the pin 20 is reduced to return the displacement amount from about 1.45 mm to 0 mm, and the load at this time is [reaction force of the coil spring 30 - frictional force (depending on the lateral pressure) at the time of pushing]. Accordingly, it is understood that, at any displacement amount of the pin 20, a difference between the upper inclined line a and the lower inclined line b becomes an amount depending on the lateral pressure, and even when the displacement amount is changed, the difference between the upper inclined line a and the lower inclined line b does not greatly change, and the lateral pressure is stable.

FIG. 7 shows a relation between the pin displacement amount [mm] and a resistance value [mΩ] by a line c. Since the lateral pressure is stable regardless of the displacement amount of the pin, it can be understood that the resistance value is substantially constant and stable at a sufficiently low value even when the displacement amount changes.

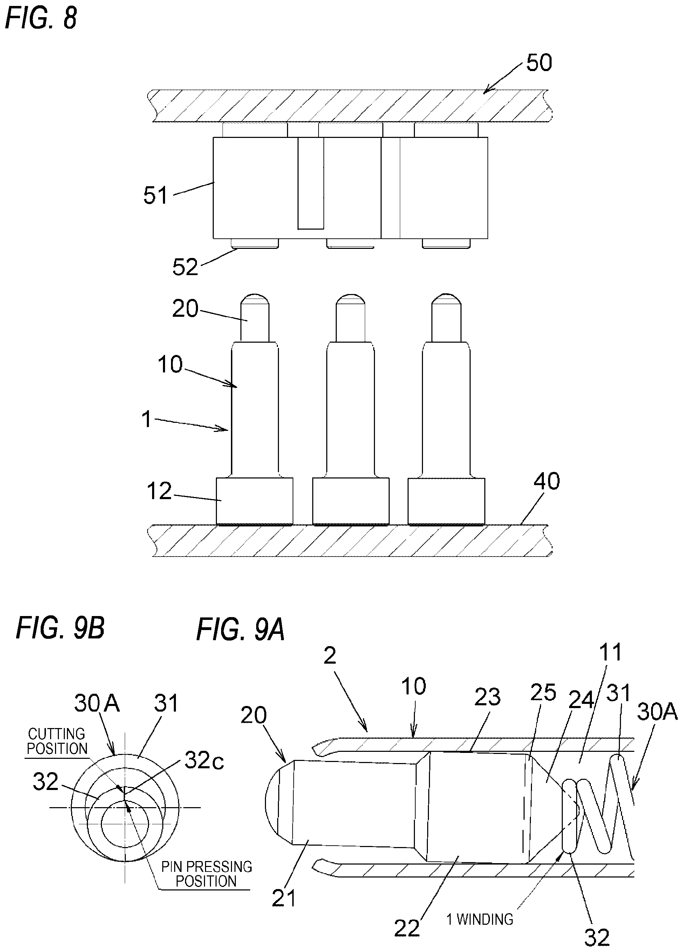

FIG. 8 is an explanatory view showing an usage example of the spring connector 1 shown in Embodiment 1. The spring connector 1 is fixed to a conductor electrode portion such as a substrate 40 of an electric device or an electronic device by soldering or the like at the flange portion 12 of the tube 10. By pressing the pin 20 of the spring connector 1 against an electrode terminal 52 provided on a housing 51 of an opposite device 50, detachable electrical connection with the electrode terminal 52 of the opposite device 50 can be made. In this case, the spring connector 1 can be used to connect a signal line, a power supply line, or the like.

According to the present embodiment, the following effects can be achieved.
(1) The coil spring 30 for biasing the pin 20 in the direction in which the pin 20 protrudes out of the tube 10 includes the roughly wound portion 31 and the densely wound portions 32 each positioned on the end portion side of the roughly wound portion 31 and engaged with the pin 20, the diameter of the densely wound portion 32 is smaller than the diameter of the roughly wound portion 31, and the central axis γ of the densely wound portion 32 and the central axis β of the roughly wound portion 31 are different from each other. That is, the densely wound portion 32 is eccentric with respect to the roughly wound portion 31, and when the pin 20 is pushed in, an eccentricity amount of the densely wound portion 32 is changed by engaging with the conical portion 24, and the lateral pressure for pressing the pin 20 against the tube inner wall surface is generated. Since the lateral pressure is generated substantially only by the eccentricity of the densely wound portion 32 with respect to the roughly wound portion 31, as shown by the difference between the upper inclined line a and the lower inclined line b in FIG. 7, it is possible to secure a substantially constant and stable lateral pressure from initial pushing without depending on the compression amount of the pin 20 in the axial direction.
(2) The pin 20 includes the inlet pipe portion 22 positioned in the tube 10, and the inlet pipe portion 22 includes the conical portion 24 that engages with the densely wound portion 32 of the coil spring 30. Since the conical portion 24 is rotationally symmetric with respect to the central axis α of the pin 20, secondary machining is not required in general lathe machining. That is, the pin 20 can be processed more easily than when the pin bottom surface is obliquely bias-cut. Although the lateral pressure function is established even when the angle θ of the conical portion 24 is 30° to 60°, approximately 45° is optimum in consideration of securing a contact portion with the tube 10 and wear during sliding.
(3) The coil spring 30 includes the roughly wound portion 31 and the densely wound portions 32 each positioned on the end portion side of the roughly wound portion 31 and engaged with the conical portion 24 of the pin 20, since the conical portion 24 of the pin 20 is inducted into and engaged with the eccentric densely wound portion 32 during assembly, the assemblability is excellent. Further, since the conical portion 24 is engaged with the inside of the inner diameter of the densely wound portion 32 to be stably fitted, the pin 20 does not rattle.
(4) Since the boundary portion 25 between the sliding portion 23 and the conical portion 24 in the inlet pipe portion 22 of the pin 20 inserted into the tube 10 has a curved shape, wear resistance between the boundary portion 25 and the inner wall of the cylindrical hollow portion 11 of the tube 10 in sliding contact is improved, and deterioration of a product can be prevented.
(5) Since the outer peripheral end of the roughly wound portion 31 and the outer peripheral end of the densely wound portion 32 are aligned on the outer side in the direction in which the central axis γ of the densely wound portion 32 is offset with respect to the central axis β of the roughly wound portion 31, the eccentricity amount when the induction of the densely wound portion 32 by the conical portion 24 of the pin 20 is taken into consideration is maximized, and the lateral pressure can be maximized. However, even when the outer peripheral end of the roughly wound portion 31 and the outer peripheral end of the densely wound portion 32 are not aligned with each other, the lateral pressure can be stabilized.
(6) The winding number of the densely wound portion 32 of the coil spring 30 is 1.5 windings, and the cutting end portion 32a is positioned on the outer side in the direction in which the central axis γ of the densely wound portion 32 is offset when viewed from the central axis β direction of the roughly wound portion 31, and thus the engagement and contact between the densely wound portion 32 and the conical portion 24 of the pin 20 is reliable. In terms of operation principle, the winding number of the densely wound portion 32 may be 2, 2.5, or the like, but 1.5 windings is preferable in that the total length of the coil spring 30 does not become long and sufficient lateral pressure can be generated.
(7) The densely wound portions 32 of the coil spring 30 are symmetrically provided on both end sides of the roughly wound portion 31. That is, the densely wound portions 32 provided on both end sides of the roughly wound portion 31 have the same central axes γ, the same eccentricity amount, and the same winding number, and thus the assemblability is good since the same performance is obtained even in an upside-down state. It is not necessary to consider an insertion direction of the coil spring 30 into the tube 10 during assembly. The assembly is realized by inserting coil spring 30 and the pin 20 into the tube 10 in this order, but since the conical portion 24 of the pin 20 is inducted into and engaged with the densely wound portion 32 of the eccentric coil spring 30, in this respect, the assemblability is also excellent.
(8) Since the central axis β of the roughly wound portion 31 of the coil spring 30 is substantially parallel to the central axis γ of the densely wound portion 32 and the central axis β of the roughly wound portion 31 is substantially a straight line, the roughly wound portion 31 hardly affects the lateral pressure when the roughly wound portion 31 is compressed, and the lateral pressure can be stabilized regardless of the compression amount of the roughly wound portion 31, that is, the push-in displacement amount of the pin 20.

### Embodiment 2

FIG. 9A and FIG. 9B are views of a main part according to Embodiment 2 of the spring connector of the present invention, in which FIG. 9A is an explanatory view of a main part of the spring connector 2, and FIG. 9B is a side view of a side of a coil spring 30A in contact with the pin. In this case, the winding number of the densely wound portion 32 in a coil spring 30A is 1, and a cutting end portion 32c is positioned on a side opposite to the central axis γ of the densely wound portion 32 that is offset with respect to the central axis β of the roughly wound portion 31.

According to Embodiment 2, since the winding number of the densely wound portion 32 is 1, the total length of the coil spring 30A can be shortened. The stability of engagement and contact between the densely wound portion 32 and the conical portion 24 of the pin 20 is better than the winding number of 1.5. Other configurations, operations, and effects are the same as those of Embodiment 1.

FIG. 9A and FIG. 9B show a case in which the winding number of the densely wound portion 32 is 1, and in Embodiment 1, the winding number of the densely wound portion 32 is 1.5, and may be 1.5 or more.

### Embodiment 3

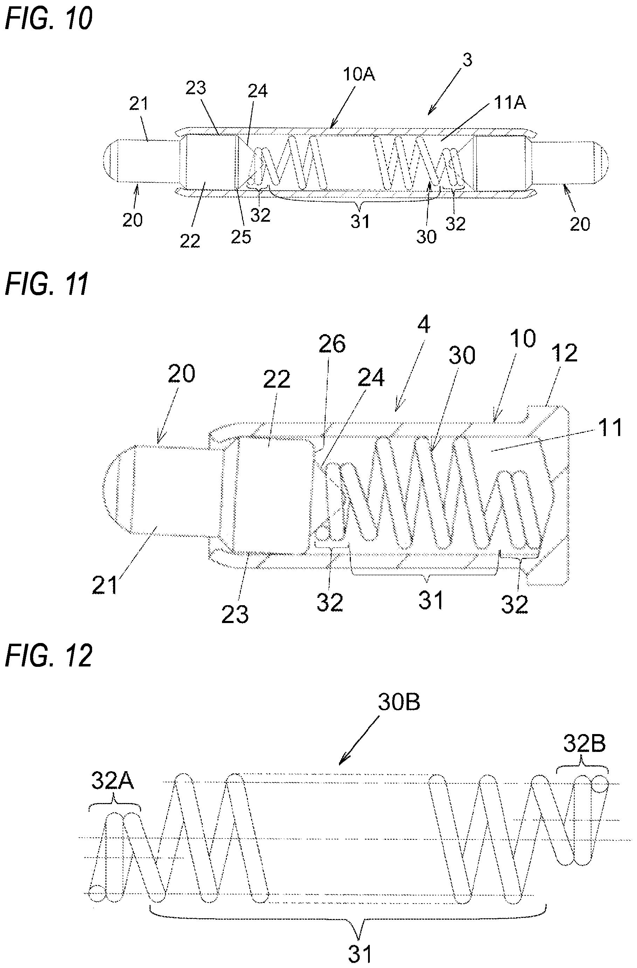

FIG. 10 is an explanatory view showing Embodiment 3 of the spring connector according to the present invention. In this case, the spring connector 3 includes a conductive tube 10A having a cylindrical penetrated hollow portion 11A, the coil spring 30 provided in the cylindrical penetrated hollow portion 11A, and a pair of conductive pins 20 slidable in the tube 10, and the pins 20 are provided on both sides of the coil spring 30. Configurations, operations, and effects other than that the pin 20 is disposed on both sides of the coil spring 30 are the same as those of Embodiment 1 described above.

According to Embodiment 3, since the pins 20 protrude from both sides of the tube 10A, for example, the pins 20 can be used as probes in which one pin is brought into contact with an electrode of an object to be measured such as an integrated circuit and the other pin is brought into contact with an electrode of an inspection substrate of a measurement device.

### Embodiment 4

FIG. 11 is an explanatory view showing Embodiment 4 of the spring connector according to the present invention. In this case, the spring connector 4 is different from Embodiment 1 in the shape of the conductive pin 20. That is, in the pin 20 of Embodiment 4, a portion (width wide portion) of the conical portion 24 of Embodiment 1 that is not directly engaged with the coil spring 30 is omitted, and an end surface of the pin 20 on a side facing the coil spring 30 has a circular ring-shaped flat surface portion 26 surrounding the conical portion 24. For example, a boundary portion between the sliding portion 23 and the flat surface portion 26 of the pin 20 has a curved shape. Other configurations are the same as those of Embodiment 1.

According to Embodiment 4, in addition to the effects of Embodiment 1, the entire length of the spring connector 4 can be shortened by omitting the width wide portion of the conical portion 24 to reduce the height. By shortening the length, processing time and a material can be reduced. An overall length of the coil spring 30 can be shortened while optimally maintaining an angle of a fitting portion (approximately 90°) of the coil spring 30 in the conical part 24. Although the angle formed by the inner wall of the cylindrical hollow portion 11 of the tube 10 and the flat surface portion 26 is 90°, the boundary portion between the sliding portion 23 and the flat surface portion 26 of the pin 20 has a curved shape, and thus good sliding properties and wear resistance can be maintained.

Although the present invention has been described with reference to the embodiments, it is to be understood by those skilled in the art that various modifications can be made to the components and the processes of the embodiments within the scope of the claims. Hereinafter, modifications will be described.

FIG. 12 is a front view showing a modification of the coil spring usable in the spring connector of the present invention. In this case, in a coil spring 30B, a densely wound portion 32A on one end portion side of the roughly wound portion 31 is offset (eccentric) to one end portion side with respect to the central axis of the roughly wound portion 31, and the densely wound portion 32B on the other side is offset (eccentric) to the other side with respect to the central axis of the roughly wound portion 31. In Embodiment 1 and the like, even when the coil spring 30B is used instead of the coil spring 30, the same effects as those of Embodiment 1 and the like can be obtained.

Embodiments and modifications of the present invention have been described above with reference to the drawings, but these are examples of the present invention, and various configurations other than those described above can also be adopted.

### REFERENCE SIGNS LIST

1, 2, 3 spring connector
10, 10A tube
11 cylindrical hollow portion
11A cylindrical penetrated hollow portion
12 flange portion
20 pin
21 protruding portion
22 inlet pipe portion
23 sliding portion
24 conical portion
25 boundary portion
26 flat surface portion
30, 30A, 30B coil spring
31 roughly wound portion
32, 32A, 32B densely wound portion
40 substrate
50 opposite device
α central axis of pin
β central axis of roughly wound portion
y central axis of densely wound portion

## Claims

1. A spring connector comprising:
a conductive tube;
a conductive pin being slidable in the tube; and
a spring provided in the tube and configured to bias the pin in a direction in which the pin protrudes from the tube, wherein
the spring includes a roughly wound portion and a densely wound portion positioned on an end portion side of the roughly wound portion and engaged with the pin, and
a diameter of the densely wound portion is smaller than a diameter of the roughly wound portion, and a central axis of the densely wound portion and a central axis of the roughly wound portion are different from each other.

2. The spring connector according to claim 1, wherein
the pin includes a protruding portion protruding outside of the tube and an inlet pipe portion positioned in the tube, and
the inlet pipe portion includes a sliding portion that is slidable with respect to an inner wall of the tube and a conical portion engaged with the densely wound portion of the spring.

3. The spring connector according to claim 2, wherein
a boundary portion between the sliding portion and the conical portion has a curved shape.

4. The spring connector according to any one of claims 1 to 3, wherein
an outer peripheral end of the roughly wound portion and an outer peripheral end of the densely wound portion are aligned on an outer side in a direction in which the central axis of the densely wound portion is offset with respect to the central axis of the roughly wound portion.

5. The spring connector according to any one of claims 1 to 3, wherein
the densely wound portion is provided on each of both end sides of the roughly wound portion.

6. The spring connector according to claim 5, wherein
central axes of the densely wound portions provided on both end sides of the roughly wound portion are offset in the same direction with respect to the central axis of the roughly wound portion.

7. The spring connector according to claim 5, wherein
central axes of the densely wound portions provided on both end sides of the roughly wound portion are coaxial with each other.

8. The spring connector according to claim 5, wherein
central axes of the densely wound portions provided on both end sides of the roughly wound portion are offset in opposite directions across a central axis of the roughly wound portion.

9. The spring connector according to any one of claims 1 to 3, wherein
a cutting end portion of the spring is positioned closer to an inner wall side of the tube than the central axis of the densely wound portion in a direction in which the central axis of the densely wound portion is offset from the central axis of the roughly wound portion.

10. The spring connector according to any one of claims 1 to 3, wherein
the central axis of the densely wound portion and the central axis of the roughly wound portion are substantially parallel to each other.

11. The spring connector according to claim 2 or 3, wherein
the inlet pipe portion has a flat surface portion surrounding the conical portion on an end surface facing the spring.
